# EUROPEAN PATENT SPECIFICATION

(11) **EP 1 521 380 B1**
(45) Date of publication and mention of the grant of the patent: **12.03.2008**
(21) Application number: 03022147.7
(22) Date of filing: 30.09.2003
(51) Int. Cl.: H04B 3/32

(54) **Apparatus and method for reducing cross-talk between transmitted signals**
Gerät und Verfahren zum Reduzieren von Übersprechen zwischen Übertragungssignalen
Appareil et procédé pour réduire la diaphonie entre signaux transmis

(43) Date of publication of application: 06.04.2005
(73) Proprietor: Infineon Technologies AG, 81669 München (DE)
(72) Inventor: Kuzmenka, Maksim, 81829 München (DE)
(74) Representative: Schoppe, Fritz

(56) References cited:
- EP-A- 1 085 672
- US-A1- 2002 199 049
- US-A1- 2003 038 664

## Description

The present invention relates to an apparatus and a method for transmitting a first and a second signal on a first and a second transmission path, and in particular, to a cross-talk compensation for transmission paths on a printed circuit board.

Cross-talk between neighboring transmission lines is a significant problem for transferring information on the transmission lines from a transmitter to a receiver. On a printed circuit board, neighboring transmission lines are coupled by a parasitic capacitance and inductance. Thus, simultaneous switching signals on neighboring transmission lines influence each other. Simultaneously rising edges or falling edges on neighboring transmission lines result in a shorter propagation time of both signal edges. Opposite edges, this is a falling and a rising edge, on neighboring transmission lines result in a longer propagation time. Even if all transmission lines have a same length and a same characteristic impedance, the simultaneously driven signals do not arrive simultaneously at the receiver. The arrival time of the signals depends on the state of the neighboring transmission lines.

A computer memory subsystem comprises a plurality of multi-line parallel busses. On an address bus and a data bus of a computer memory subsystem, all signals are driven simultaneously at the transmitter side. This increases the effect of cross-talk. Cross-talk is further increased as neighboring transmission lines often run in parallel due to a limited available space on a printed circuit board and due to routing constrains.

If a random bit sequence is driven on two neighboring transmission lines, a part of the received bits will be delayed and another part will arrive earlier. This results in a timing uncertainty of the transmitted bits at the receiver. In high data rate designs, the timing uncertainty makes it more difficult to receive the bits. Due to the timing uncertainty a data valid interval becomes very small, especially if several neighboring traces switch simultaneously with a rising or simultaneously with a falling edge.

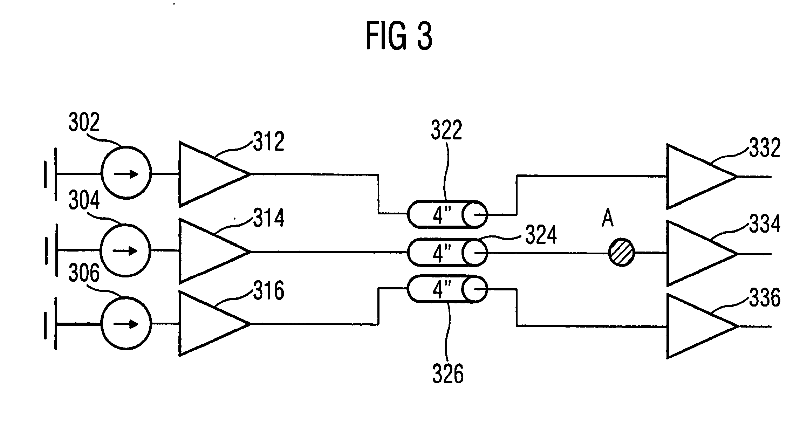

Fig. 3 shows a schematic view of a multi-line parallel bus which comprises three neighboring transmission lines. A first 302, a second 304 and a third 306 signal are driven by a first 312, a second 314 and a third 316 driver on a first 322, a second 324 and a third 326 transmission line. The signals 302, 304, 306 are received by a first 332, a second 334 and a third 336 receiver.

In multi-line busses which are typically for memory systems, Cross-talk is increased by a parallel routing of neighboring transmission lines.

In the embodiment shown in Fig. 3, the transmission lines 322, 324, 326 are printed circuit board transmission lines which have a length of 101 mm, a width of 0.1 mm, a spacing between neighboring transmission lines of 0.1 mm, a thickness of 0.046 mm, a distance to a ground layer (not shown) of 0.087 mm, a dielectric permittivity of 4.5 and a characteristic trace impedance of approximately 60 Ω.

The drivers 312, 314, 316 each comprise a 40 Ω resistor, a high level of 1.5 V, a low level of 0 V and a rise and fall time of 250 ps. The signals 302, 304, 306 each carry a 256 bit non-correlated pseudo-random bit sequence at a bit rate of 1.6 Gbit/s. The receiver 332, 334, 336 each comprise a 60 Ω resistor connected to a middle level voltage of 1.5 V.

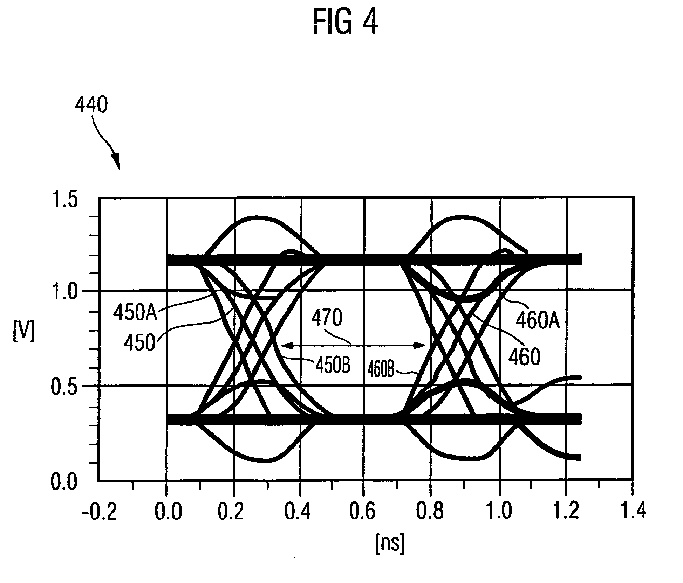

Fig. 4 shows an eye diagram 440 of the second signal 304 of Fig. 3, taken at the place marked by an "A".

The eye diagram 440 shows a falling edge 450 and a rising edge 460 of the second signal which are not influenced by the neighboring signals shown in Fig. 3. Further, the eye diagram 440 shows influenced rising edges 450a, 450b and influenced falling edges 460a, 460b of the second signal.

The uninfluenced edges 450, 460 relate to a state, in which neighboring signal lines are not switching or are both switching in an opposite direction.

The influenced edges 450a, 460a arrive earlier than the uninfluenced edges 450, 460. This happens as the neighboring signals switch in the same direction as the second signal. The influenced edges 450b, 460b arrive later than the uninfluenced edges 450, 460. This happens if the neighboring signals switch in an opposite direction than the second signal.

An opening 470 of the eye defines a time between two switching events, in which the state of the second signal is defined and a valid value can be sampled by a receiver. As can be seen, the opening 470 of the eye is reduced due to the influenced edges 450a, b, 460a, b. In this embodiment, the opening of the eye has a duration of 500 ps.

Especially in high data rate designs, the opening 470 of the eye becomes too small for securely sampling the second signal. In order to increase the opening 470 of the eye, cross-talk on the transmission lines has to be reduced. According to the prior art, cross-talk is reduced by increasing a spacing between neighboring transmission lines or by including additional grounded guard traces. Due to space limitations and routing constrains, these methods are often not feasible.

US-A1-2002,199049 describes a layout with signals of different busses being arranged such that adjacent signal lines are of different busses. Drivers drive signals of a first bus and a second bus. When signals of the first bus change, signals of the second bus are at a definite state.

US-A1-2003,038664 describes a semiconductor integrated circuit having a first circuit, which outputs clock signals. Each clock signal is delayed by a delay time from reference signal. In order to reduce the clock skew between neighbouring clock signals and the jitters of respective clock signals without increasing the area of the semiconductor integrated circuit, a first wiring permute part is proposed in order to arranged the positions of edges of adjacent situated clock signals to have a sufficient time different, which makes it possible to eliminate the effect of cross-talk between neighbouring clock signals.

It is the object of the present invention, to provide an apparatus and a method for transmitting a first and a second signal on neighboring transmission paths which compensates cross-talk between the first and the second signal in a cost- and space-effective manner.

This object is achieved by an apparatus for transmitting a first and a second signal according to claim 1 and a method for transmitting a first and a second signal according to claim 8.

The present invention is based on the finding that cross-talk between two neighboring transmission paths can be compensated by delaying one of the two signals such that the two signals switch asynchronously.

The proposed method for cross-talk compensation can be advantageously used in a multi-line parallel bus. It does not require additional routing space and does not cause additional costs as a necessary delay-line can be implemented in an integrated circuit without additional effort. Alternatively, the proposed method allows to reduce a spacing between neighboring transmission paths without increasing the effect of cross-talk.

According to a further embodiment of the present invention, the apparatus for transmitting a first and a second signal comprises additional means for providing separate strobesignals which allow a receiver to latch the transmitted signals.

Preferred embodiments of the present invention are described herein after, making reference to the append drawings.
- Fig. 1: shows a schematic view of an apparatus for transmitting a first and a second signal on a first and a second transmission path;
- Fig. 2: shows an eye diagram of a signal shown in Fig. 1;
- Fig. 3: shows a schematic view of an apparatus for transmitting a first and a second signal on a first and a second transmission path according to the prior art; and
- Fig. 4: shows an eye diagram of a signal shown in Fig. 3.

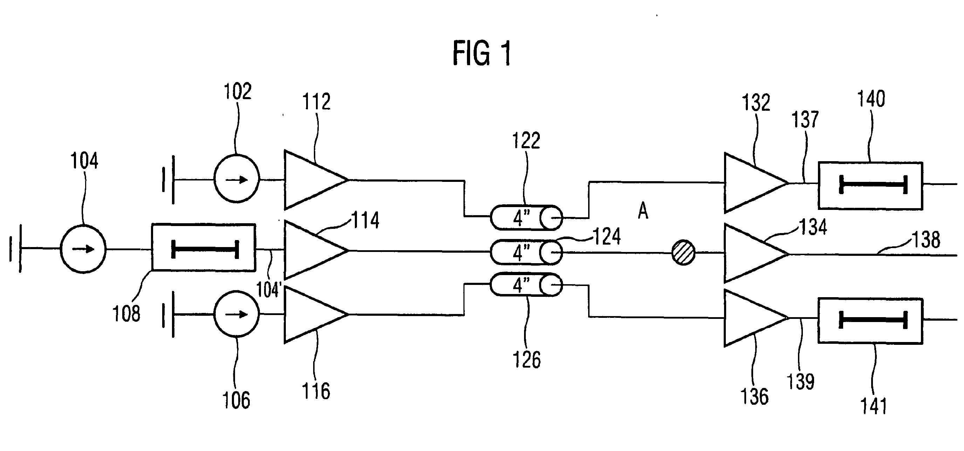

Fig. 1 shows a schematic view of an apparatus for transmitting a first and a second signal on a first and a second transmission path. This embodiment comprises a first signal 102, a second signal 104 and a third signal 106. The first and the third signal 102, 106 both represent a first signal according to the present invention which effect the second signal 104. The second signal 104 is connected to a delay line 108 which delays the second signal 104 by a defined delay time period and provides a delayed signal 104'. The first signals 102, 106 and the delayed signal 104' are driven by a first driver 112, a second driver 114 and a third driver 116 on a first transmission path 122, a second transmission path 124 and a third transmission path 126. The transmission paths 122, 124, 126 are connected to a first receiver 132, a second receiver 134 and a third receiver 136 which sample the corresponding transmitted signals 102, 104', 106 and provide a first received signal 137, a second received signal 138 and a third received signal 139. In this embodiment, the first and the third received signals 137, 139 are connected to a second and a third delay line 140, 141.

In the present embodiment, the drivers 112, 114, 116 and the receivers 132, 134, 136 are drivers and receivers in an integrated circuit. Accordingly the delay lines 108, 138, 139 are realized in an integrated circuit, too. The transmission paths 122, 124, 126 are transmission lines on a printed circuit board. The signals 102, 104, 108, the drivers 112, 114, 116, the transmission paths 122, 124, 126 and the receivers 132, 134, 136 are characterized according to corresponding signals, drivers, transmission paths and receivers of the prior art embodiment as described in Fig. 3.

According to the invention, the second signal 104 is delayed by the delay line 108 by a delay period such that the edges of the neighboring signals 102, 106 do not coincide with an edge of the delayed signal 104'. The delay period depends on a relationship between the switching times of the first signals 102, 106 and the second signal 104. If the relationship is not known or is changing, a clock signal (not shown) is used for synchronizing the first signals 102, 106 and the second signal 104.

In order to align the received signals 137, 138, 139, the receivers 132, 136 of the first signals are connected to the delay lines 140, 141 which delay the received first signals 137, 139 by the same delay time period as the delayed signal 104' is delayed by the delay line 108 at the transmitter side.

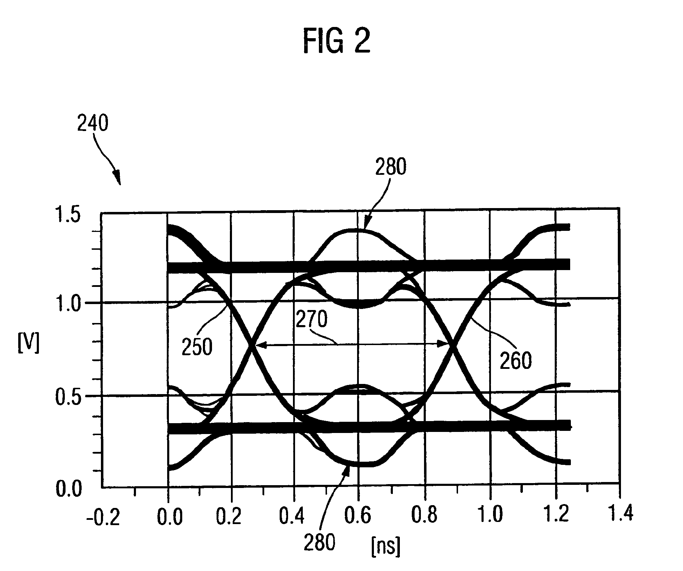

An eye diagram 240 of the delayed signal 104' shown in Fig. 1 at the place marked by an "A" is shown in Fig. 2. The eye diagram 240 shows a falling edge 250 and a rising edge 260 of the delayed signal. As can be seen from Fig. 2, the embodiment as described in Fig. 1 prevents an influence of the neighboring transmission lines on the edges 250, 260 of the delayed signal. Therefore, the opening 270 of the eye has a maximum width. In this embodiment the opening 270 of the eye has a duration of 612 ps which is longer than the opening of the influenced eye diagram shown in Fig. 4.

In this embodiment, the first and second signals switch periodically with a bit-time period and the delay line period is such that the second signal is delayed by half a bit time. Therefore, edges of the first signals do not effect the delayed signal while it is switching but while it is in a stable high or low state 280. Preferably, a voltage margin in the stable state 280 is such that a ring-back due to the cross-talk effect does not effect a signal integrity.

According to a further embodiment, the second signal is not delayed by a half bit-time period but by a shorter delay time period which equals a transient time period of the first signal. Thus, in a low data rate design, it might be unnecessary to delay the first signal at the receiver side.

According to a further embodiment, the apparatus for transmitting a first and a second signal comprises strobesignals. A first strobe-signal is driven correspondingly to the first signal and a second strobe-signal is driven correspondingly to the second signal. The strobe-signal indicate a switching of the first signal and the delayed signal. Thus, the delay lines on the receiver side are not necessary and the data rate can be increased.

In an embodiment comprising a multi-line parallel bus, every second transmission path signal is delayed. The multi-line parallel bus can be part of a memory sub system or be part of any other design which comprises at least to parallel transmission paths. The transmission paths are not limited to lines on a printed circuit board but can be any transmission paths on which transmitted signals effect each other on neighboring transmission paths.

### List of reference numbers

- 102: first signal
- 104: second signal
- 106: third signal
- 108: delay line
- 112: first driver
- 114: second driver
- 116: third driver
- 122: first transmission path
- 124: second transmission path
- 126: third transmission path
- 132: first receiver
- 134: second receiver
- 136: third receiver
- 138, 139: receiver delay lines

- 240: eye diagram
- 250: falling edge
- 260: rising edge
- 270: opening of the eye diagram
- 280: stable states

- 302, 304, 306: first, second, third signals
- 312, 314, 316: first, second, third drivers
- 322, 324, 326: first, second, third transmission lines
- 332, 334, 336: first, second, third receivers

- 440: eye diagram
- 450: uninfluenced rising edge
- 460: uninfluenced falling edge
- 450a, b: influenced rising edges
- 460a, b: influenced falling edges
- 470: opening of the eye

## Claims

1. Apparatus for transmitting a first signal (102) on a first transmission path (122) and a second signal (104) on a second transmission path (124), wherein the transmission paths are arranged such that a cross-talk between the transmission paths takes place when the first and the second signal are transmitted on the first and second transmission path, said apparatus comprising:
a first means (112) for driving the first signal on the first transmission path;
a means (108) for delaying the second signal by a delay time period and for providing a delayed signal (104');
a second means (114) for driving the delayed signal on the second transmission path;
wherein the delay time period is such that rising and falling edges of the first signal do not coincide with rising (260) and falling (250) edges of the delayed signal; and
comprising a first and a second means (132, 134) for receiving the transmitted first and the delayed signal and for providing a received first signal (137; 139) and a received second signal (138); and
a means for delaying the received first signal by the delay time period.

2. Apparatus according to claim 1, further comprising a clock signal for synchronizing the first signal and the second signal.

3. Apparatus according to one of claims 1 to 2, wherein the first and the second signals (102, 104) are driven periodically with a bit time period and wherein the delay time period is such that the delayed signal (104') is driven between one third or two thirds of the bit time period after the first signal is driven.

4. Apparatus according to one of claims 1 to 3, wherein the delay time period is such that the delayed signal is driven after a transient effect of the first signal.

5. Apparatus according to one of claims 1 to 4, further comprising a first and a second means for driving a first and a second strobe-signal, wherein the first strobe-signal corresponds to the first signal and wherein the second strobe-signal corresponds to the delayed signal.

6. Apparatus according to one of claims 1 to 5, wherein the means for delaying is a delay line.

7. Apparatus according to one of claims 1 to 6, wherein the first and the second transmission paths are printed circuit board transmission lines.

8. Method for transmitting a first signal on a first transmission path and a second signal on a second transmission path, wherein the transmission paths are arranged such that a cross-talk between the transmission paths takes place when the first and second signal are transmitted on the first and the second transmission path, said method comprising the steps of:
driving the first signal on the first transmission path;
delaying the second signal by a delay time period and providing a delayed signal;
driving the delayed signal on the second transmission path;
wherein the delay time period is such that rising and falling edges of the first signal do not coincide with rising and falling edges of the delayed signal; and
receiving the transmitted first and the delayed signal and providing a received first signal (137; 139) and a received second signal (138); and
delaying the received first signal by the delay time period.

## Patentansprüche

1. Vorrichtung zum Senden eines ersten Signals (102) auf einem ersten Sendeweg (122) und eines zweiten Signals (104) auf einem zweiten Sendeweg (124), wobei die Sendewege derart angeordnet sind, dass ein Übersprechen zwischen den Sendewegen stattfindet, wenn das erste und das zweite Signal auf dem ersten und zweiten Sendeweg gesendet werden, wobei die Vorrichtung folgende Merkmale aufweist:
eine erste Einrichtung (112) zum Ansteuern des ersten Signals auf dem ersten Sendeweg;
eine Einrichtung (108) zum Verzögern des zweiten Signals um eine Verzögerungszeitperiode und zum Bereitstellen eines verzögerten Signals (104');
eine zweite Einrichtung (114) zum Ansteuern des verzögerten Signals auf dem zweiten Sendeweg;
wobei die Verzögerungszeitperiode derart ist, dass ansteigende und abfallende Flanken des ersten Signals nicht mit ansteigenden (260) und abfallenden (250) Flanken des verzögerten Signals zusammenfallen; und
eine erste und eine zweite Einrichtung (132, 134) zum Empfangen des gesendeten ersten und des verzögerten Signals und zum Bereitstellen eines empfangenen ersten Signals (137; 139) und eines empfangenen zweiten Signals (138); und
eine Einrichtung zum Verzögern des empfangenen ersten Signals um die Verzögerungszeitperiode.

2. Vorrichtung gemäß Anspruch 1, die ferner ein Taktsignal zum Synchronisieren des ersten Signals und des zweiten Signals aufweist.

3. Vorrichtung gemäß einem der Ansprüche 1 bis 2, bei der das erste und das zweite Signal (102, 104) mit einer Bitzeitperiode periodisch angesteuert werden, und bei der die Verzögerungszeitperiode derart ist, dass das verzögerte Signal (104') zwischen einem Drittel oder zwei Dritteln der Bitzeitperiode angesteuert wird, nachdem das erste Signal angesteuert wird.

4. Vorrichtung gemäß einem der Ansprüche 1 bis 3, bei der die Verzögerungszeitperiode derart ist, dass das verzögerte Signal nach einem Transientenübergangseffekt des ersten Signals angesteuert wird.

5. Vorrichtung gemäß einem der Ansprüche 1 bis 4, die ferner eine erste und eine zweite Einrichtung zum Ansteuern eines ersten und eines zweiten Strobesignals aufweist, wobei das erste Strobesignal dem ersten Signal entspricht und wobei das zweite Strobesignal dem verzögerten Signal entspricht.

6. Vorrichtung gemäß einem der Ansprüche 1 bis 5, bei der die Einrichtung zum Verzögern eine Verzögerungsleitung ist.

7. Vorrichtung gemäß einem der Ansprüche 1 bis 6, bei der der erste und zweite Sendeweg Gedruckte-Schaltungsplatine-Sendeleitungen sind.

8. Verfahren zum Senden eines ersten Signals auf einem ersten Sendeweg und eines zweiten Signals auf einem zweiten Sendeweg, wobei die Sendewege derart angeordnet sind, dass ein Übersprechen zwischen den Sendewegen stattfindet, wenn das erste und zweite Signal auf dem ersten und zweiten Sendeweg gesendet werden, wobei das Verfahren folgende Schritte aufweist:
Ansteuern des ersten Signals auf dem ersten Sendeweg;
Verzögern des zweiten Signals um eine Verzögerungszeitperiode und Bereitstellen eines verzögerten Signals;
Ansteuern des verzögerten Signals auf dem zweiten Sendeweg;
wobei die Verzögerungszeitperiode derart ist, dass ansteigende und abfallende Flanken des ersten Signals nicht mit ansteigenden und abfallenden Flanken des verzögerten Signals zusammenfallen; und
Empfangen des gesendeten ersten und des verzögerten Signals und Bereitstellen eines empfangenen ersten Signals (137; 139) und eines empfangenen zweiten Signals (138); und
Verzögern des empfangenen ersten Signals um die Verzögerungszeitperiode.

## Revendications

1. Appareil pour transmettre un premier signal (102) sur un premier trajet de transmission (122) et un deuxième signal (104) sur un deuxième trajet de transmission (124), dans lequel les trajets de transmission sont disposés de sorte qu'une diaphonie entre les trajets de transmission ait lieu lorsque le premier et le deuxième signal sont transmis sur le premier et le deuxième trajet de transmission, ledit appareil comprenant:
un premier moyen (112) destiné à entraîner le premier signal sur le premier trajet de transmission;
un moyen (108) destiné à retarder le deuxième signal d'un laps de temps de retard et à fournir un signal retardé (104');
un deuxième moyen (114) destiné à entraîner le signal retardé sur le deuxième trajet de transmission;
dans lequel le laps de temps de retard est tel que les flancs montant et descendant du premier signal ne coïncident pas avec les flancs montant (260) et descendant (250) du signal retardé; et
comprenant un premier et un deuxième moyen (132, 134) destinés à recevoir le premier signal transmis et le signal retardé et à fournir un premier signal reçu (137; 139) et un deuxième signal reçu (138); et
un moyen destiné à retarder le premier signal reçu du laps de temps de retard.

2. Appareil selon la revendication 1, comprenant par ailleurs un signal d'horloge destiné à synchroniser le premier signal et le deuxième signal.

3. Appareil selon l'une des revendications 1 à 2, dans lequel les premier et deuxième signaux (102, 104) sont entraînés périodiquement avec un laps de temps de bits et dans lequel le laps de temps de retard est tel que le signal retardé (104') soit entraîné entre un tiers ou deux tiers du laps de temps de bits après que soit conduit le premier signal.

4. Appareil selon l'une des revendications 1 à 3, dans lequel le laps de temps de retard est tel que le signal retardé soit entraîné après un effet transitoire du premier signal.

5. Appareil selon l'une des revendications 1 à 4, comprenant par ailleurs un premier et un deuxième moyen destinés à entraîner un premier et un deuxième signal d'échantillonnage, où le premier signal d'échantillonnage correspond au premier signal et où le deuxième signal d'échantillonnage correspond au signal retardé.

6. Appareil selon l'une des revendications 1 à 5, dans lequel le moyen destiné à retarder est une ligne à retard.

7. Appareil selon l'une des revendications 1 à 6, dans lequel les premier et deuxième trajets de transmission sont des lignes de transmission de plaque de circuit imprimé.

8. Procédé pour transmettre un premier signal sur un premier trajet de transmission et un deuxième signal sur un deuxième trajet de transmission, dans lequel les trajets de transmission sont disposés de sorte qu'une diaphonie entre les trajets de transmission ait lieu lorsque le premier et le deuxième signal sont transmis sur le premier et le deuxième trajet de transmission, ledit procédé comprenant les étapes consistant à:
entraîner le premier signal sur le premier trajet de transmission;
retarder le deuxième signal d'un laps de temps de retard et fournir un signal retardé;
entraîner le signal retardé sur le deuxième trajet de transmission;
dans lequel le laps de temps de retard est tel que les flancs montant et descendant du premier signal ne coïncident pas avec les flancs montant et descendant du signal retardé; et
recevoir le premier signal transmis et le signal retardé et fournir un premier signal reçu (137; 139) et un deuxième signal reçu (138); et
retarder le premier signal reçu du laps de temps de retard.
